# EUROPEAN PATENT SPECIFICATION

(11) **EP 0 580 187 B1**
(45) Date of publication and mention of the grant of the patent: **02.07.1997**
(21) Application number: 93113862.2
(22) Date of filing: 31.10.1989
(51) Int. Cl.: G01R 33/38, G01R 33/60, H01F 7/02

(54) **Magnetic field generating device for ESR system**
Vorrichtung zur Erzeugung eines Magnetfeldes für ein Elektronenspinresonanz-System
Dispositif pour produire un champ magnétique destiné à un système à résonance de spin électronique

(30) Priority: 16.06.1989 JP 154875/89; 24.08.1989 JP 218233/89
(43) Date of publication of application: 26.01.1994
(62) Divisional of application: 89311260.7
(73) Proprietor: SUMITOMO SPECIAL METALS COMPANY LIMITED, Osaka City Osaka (JP)
(72) Inventor: Nakanishi, Akio, c/o YAMAZAKI SEISAKUSHO, SUMITOMO, Shimamoto-cho, Mishima-gun, Osaka (JP); Konishi, Kenta, c/o YAMAZAKI SEISAKUSHO, SUMITOMO, Shimamoto-cho, Mishima-gun, Osaka (JP); Kobayashi, Takashi, c/o YAMAZAKI SEISAKUSHO, Shimamoto-cho, Mishima-gun, Osaka (JP)
(74) Representative: Livsey, Gilbert Charlesworth Norris

(56) References cited:
- EP-A- 0 161 782
- WO-A-88/06798
- US-A- 3 460 083
- US-A- 3 860 895
- US-A- 4 122 386
- AMERICAN JOURNAL OF PHYSICS vol. 44, no. 7 , 1 July 1976 , NEW YORK, US pages 655 - 657 L.W. RUPP ET AL. 'MINIATURE MAGNET FOR ELECTRON SPIN RESONANCE EXPERIMENTS'
- IBM TECHNICAL DISCLOSURE BULLETIN vol. 20, no. 4 , 1 September 1977 , NEW YORK, US pages 1526 - 1527 G.P. DOUBLE 'MANUAL FIELD ADJUSTMENT FOR NMR MAGNET'
- PATENT ABSTRACTS OF JAPAN vol. 8, no. 219 (P-306)(1656) 5 October 1984 & JP-A-59 102 143 (HITACHI SEISAKUSHO K.K.)

## Description

The present invention concerns a magnetic field generating device for an electron spin resonance system (hereinafter referred to as an "ESR system").

ESR systems are generally used in the field of research and development. Since ESR systems can detect unpaired electrons due to natural radiation damage of test objects, and because they can be used to measure the ages of archaeological remains, as well as geological, mineral and fossil remains, they have increasingly been utilised recently in the field of archaeology and earth science.

For the magnetic field generating device forming an essential part of an ESR system, it is usually necessary to form a magnetic field of about 0.3 to 0.4 tesla (3000-4000 gauss) at high accuracy and uniformity in the space in which a test object is arranged and, such type of magnetic field generating device should be capable of varying the magnetic field between the magnetic poles of magnets arranged opposite to each other leaving a desired space therebetween (for the test object to be placed therein) while the magnetic field is made to keep a high degree of uniformity even after having been so varied.

### Description of the Prior Art

In the magnetic field generating device used for ESR systems, electromagnets have usually been employed. It is easy to generate and continuously change a magnetic field in a desired space by continuously varying a current applied to the electromagnets but this involves a drawback that the entire device becomes large-sized and expensive.

Further, there has been proposed a structure using only permanent magnets as a magnetic field generating source so that the magnetic field intensity is changed by changing the opposing distance (length of the space) between the permanent magnets (see e.g. EP-A-0 161 782).

However, this structure has also had the disadvantage that when the opposing distance is changed, the degree of uniformity of the magnetic field is impaired due to various causes including the deviation of the axis of one of the opposing permanent magnets from that of the other.

The degree of uniformity of the magnetic field in an ESR system is usually required to be better than 0.01 %, and accordingly, there has not been known a device using a magnetic circuit comprising permanent magnets which is capable of reliably achieving this.

It is an object of the present invention to provide a magnetic field generating device for an ESR system having the capability whereby the magnetic field intensity at the measuring gap may be varied and finely adjusted continuously, with high accuracy and precision, while maintaining the high degree of uniformity of the magnetic field intensity which is required.

Preferably the range of adjustments to be achieved is of the order of ± 10⁻² tesla (100 gauss); and preferably also the adjustment should be so fine, and preferably stepless, that accuracy within ± 10⁻⁴ tesla (1 gauss) can be obtained; always with a uniformity of field at the measuring gap of better than 0.01 %.

Another object of the present invention is to provide a small-sized and inexpensive magnetic field generating device used for an ESR system; while a further object of the present invention is to provide a magnetic field generating device for an ESR system of improved operational efficiency and simplicity.

The present invention is defined in claim 1 and the dependent claims.

In its broadest aspect the present invention provides a magnetic field generating device for an electron spin resonance ("ESR") system in which two permanent magnets are attached to two arms of a yoke so that such magnets are in opposed spaced relationship, a main flux gap being located between such magnets, and according to the invention a means is provided for continuously varying the intensity of the magnetic field in the main flux gap located between such magnets; said means comprising two movable yoke members provided between the yoke arms, each of said movable yoke members being in indirect contact with one of the yoke arms and said movable yoke members being arranged opposed to one another so as to define an auxiliary flux gap between them, whereby the flux path which extends through said main flux gap also extends through said yoke arms, said movable yoke members and said auxiliary gap; and including means whereby said two movable yoke members are simultaneously movable towards or away from one another so that the auxiliary flux gap is formed between the said movable yoke members is continuously variable.

Advantageously, the length and resistance of the magnetic flux path are substantially equal and symmetrical with respect to a median plane in which the main flux gap lies.

Means are preferably provided for applying a magnetic field by means of at least one induction coil to the poles of the members defining the or each auxiliary flux gap, thereby to increase or reduce the flux in said auxiliary flux gap, thus modifying the sensitivity of variations in the magnetic field in the main flux gap in response to movement of said movable yoke members.

The invention achieves a magnetic field generating device for an electron spin resonance (ESR) system, with a pair of permanent magnets carried within a fixed yoke, there being a magnetic field generated in a space of constant size defined between the opposed poles of the two permanent magnets and constituting a main flux gap for receiving a test object which is subject to a magnetic field of 0.3 to 0.4 tesla (3000-4000 gauss). This system includes associated with the fixed yoke and arranged in the magnetic flow path which extends through the main flux gap, at least one auxiliary flux gap defined between opposed magnetic poles at least one of which is movable to effect variation of the size of that auxiliary flux gap so as to alter the resistance of the flux path extending through said permanent magnets said yoke and each auxiliary flux gap, and thereby to change the field intensity in the fixed flux gap.

The present invention, according to another aspect, provides a magnetic field generating device for an ESR system, in which a solenoid or induction coil is disposed around at least one movable yoke member for stably varying the magnetic field intensity linearly in the space with unproved operability and a DC current is supplied to the solenoid coil to superimpose a weak magnetic field, for example, of about ± 10⁻² tesla (100 gauss) to the space thereby making the magnetic field variable in the space.

By these measures a reliable system is achieved with the capability that the field intensity in the fixed flux gap can be changed continuously with fine adjustment within predetermined limits e.g., in the range of ± 10⁻² tesla (100 gauss) while preserving uniformity of better than 0.01 % in the field intensity in the fixed flux gap where a test object is to be measured. As will be seen below these adjustments can usually be made with a high accuracy of say +/- 10⁻⁴ tesla (1 gauss).

The invention in its various aspects will be further described with reference to the accompanying drawings, in which:-
Figure 1 is a side elevational view, partially in vertical section, of a fourth embodiment of a magnetic field generating device for an ESR system according to the present invention;
Figure 2 is a side elevational view partially in vertical section, of the embodiment of Figure 4 modified to include an induction coil;
Figure 3(a) and 3(b) are vertical cross sectional view and a plan view of one embodiment of a magnetic pole piece for incorporation in an ESR system according to the present invention,
Figure 4 (a) and 4(b) are vertical cross sectional view and a plan view of a further embodiment of a magnetic pole piece for incorporation in an ESR system according to the present invention;
Figure 5 is a graph showing the distribution of magnetic field in a space for illustrating the function of movable yokes in a magnetic field generating device for on ESR system shown in Figure 9;
Figure 6 is a graph showing the change of magnetic field in a space for illustrating the function of an induction or solenoid coil in a magnetic field generating device for an ESR system shown in Figure 9;

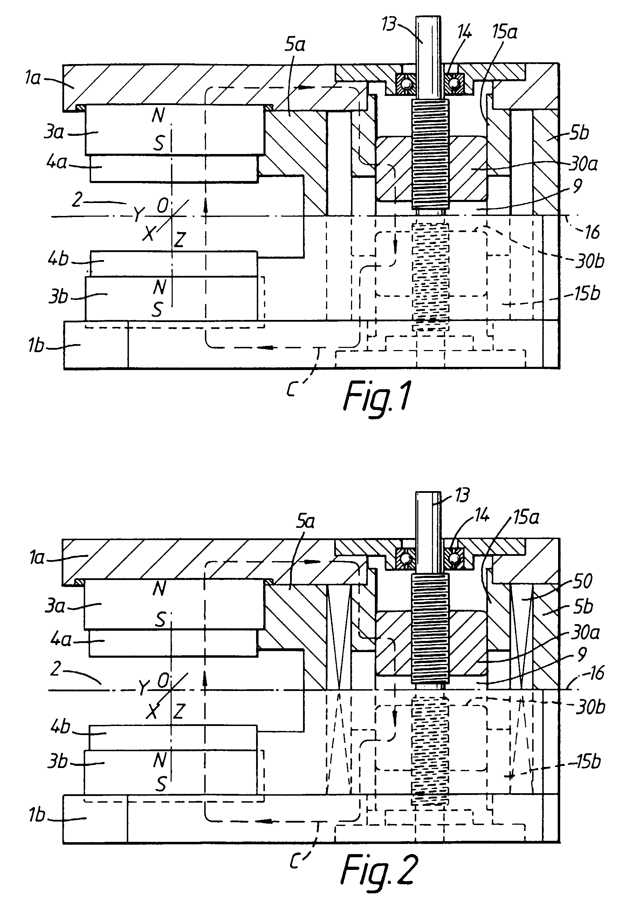

In Figure 1, a main flux gap 2 of fixed size is formed between a pair of permanent magnets 3a and 3b carried on a pair of stationary yokes 1a and 1b. Magnetic pole pieces 4a and 4b are shown affixed respectively to the opposing surfaces of the permanent magnets 3a and 3b. A test specimen will be disposed and subjected to a magnetic field in the measuring space or main flux gap 2. Detector means not shown will be provided for measuring the characteristics of the test specimen being sought.

In the construction as shown in Figure 1 a sleeve 13 is disposed perpendicular to the central plane of the flux gap 2 and two threads are formed on the sleeve 13 extending in directions opposite to each other, in the upper and lower portions of the sleeve, with respect to the central plane of the main flux gap 2. A pair of movable yokes 30a and 30b are screw-coupled to the sleeve 13 which can be rotated to vary the distance separating the movable yoke members and hence the size of the space 9. In addition, so long as the distance between the opposing surfaces of the movable yoke members can be changed continuously to vary the magnetic resistance in the magnetic path, the shape, etc., of the movable yokes can optionally be selected and, further, any known moving means such as a rack-pinion, hydraulic piston and slide mechanism may be employed. Preferably also the flow paths on the two sides of the main flux gap 2 are made as similar as possible, with the or each auxiliary flux gap 9 being disposed symmetrically in the flow path so that the flux path has two parts of substantially equal length and resistance.

When the size of the auxiliary flux gap 9 is changed, e.g. the distance between the opposing pole surfaces of the yoke members is changed, the magnetic field in the main flux gap 2 defined between the permanent magnets 3a and 3b, can be varied continuously and steplessly with fine adjustment and with a high degree of precision. But it is desirable to take the following points into consideration in order to linearly vary the magnetic field in the main flux gap while maintaining at a high accuracy i.e. of less than ± 10-4 tesla (1 gauss).

Thus it should be noted that the change in the distance across the space between the opposing surfaces of a pair of movable yoke members is not always in a proportional relationship with the change of the magnetic field in the space, and accordingly for varying the magnetic field at a desired accuracy, it is desirable to monitor changes in the magnetic field intensity by means of known measun'ng means. Control of the closing or opening movements of a pair of movable yoke members can then be achieved based on the detected values.

In the present invention, the shape of the fixed yoke arms to which permanent magnets are attached may be optional, for example, in the form of a square plate or the like, depending on the shape of the permanent magnets used, magnetic characteristics, etc. For the permanent magnets serving as a magnetic field generating source, it is desired to select a known material, shape, etc., for example, magnets of a rare earth group or of a ferritic material, depending on the required magnetic field intensity and the size of the device. In particular, where the reduction in the size is required, it is desirable to use FeB-R series magnet (in which R means rare earth element mainly composed of Nd and Pr) (for example, NEOMAX, trade name: manufactured by Sumitomo Special Metal Co) having a high energy source. For each permanent magnet, a plurality of block form permanent magnets may be combined and integrated depending on desired size and configuration.

Further, there may be attached a magnetic pole piece to each of the opposing surfaces of the pair of permanent magnets so as to improve the degree of uniformity of the magnetic field according to necessity. The magnetic pole piece contributes to the moderation of the scattering in the magnetic properties of the permanent magnets and contributes to effective concentration of magnetic fluxes in the space constituting the main flux gap, in particular, in the case where a plurality of block-form permanent magnets are employed.

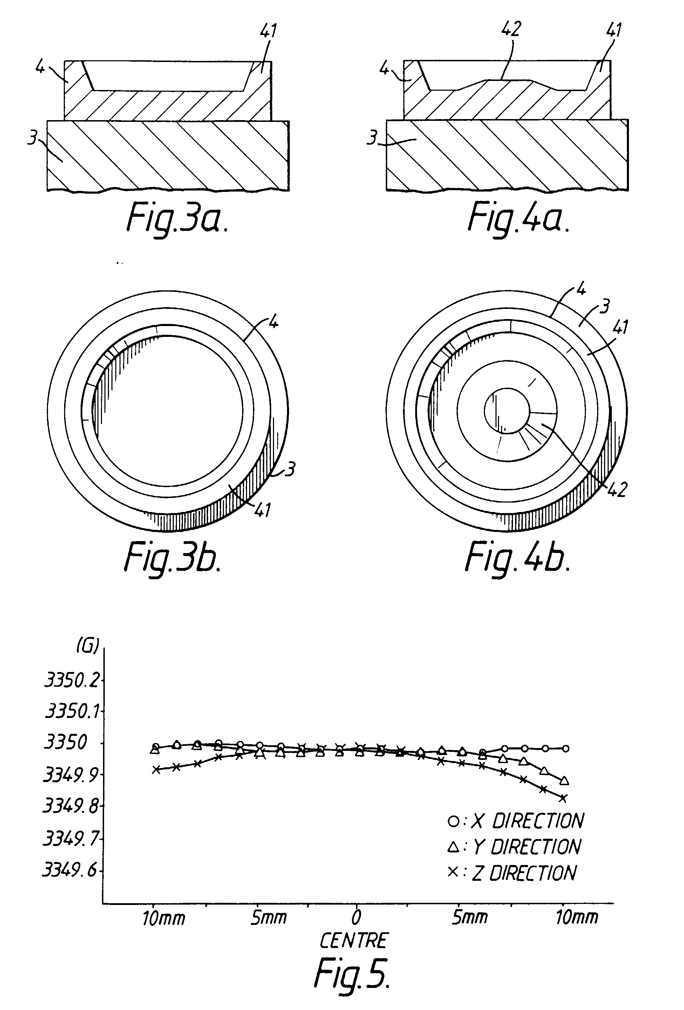

For the construction of the magnetic pole pieces, and as shown in Figures 3 and 4, it is desirable to dispose an annular protrusion 41 having a trapezoidal cross section at the periphery of the magnetic pole piece 4 and/or dispose a convex protrusion 42 having a trapezoidal cross section at the central portion. Further, there may also be employed various other constructions, such as the provision of a plurality of magnetic pieces for adjusting the magnetic field, disposed at a required position on the opposing surfaces of the space between the magnetic pole pieces 4 as required.

Further referring to Fig 1, each of the movable yokes 30a and 30b is a sliding fit within one of a pair of sleeves 15a and 15b made of magnetic material and coaxially disposed with the shaft 13 between the plate-like yoke arms la and lb, so that the movable yoke members 30a and 30b move slidably along with the rotation of the shaft 13 and are brought closer and apart from each other with respect to the central gap plane 16 depending on the rotating direction.

### Operation

With the above-described arrangement shown in Figure 1, in the magnetic field generating device for an ESR system, there is formed a magnetic path shown by a broken line C, that is, a magnetic path in which magnetic fluxes flow from the permanent magnet 3a, plate-like yoke arm la, sleeve 15a, movable yoke member 30a, yoke gap 9, movable yoke member 30b, sleeve 15b, plate-like yoke arm lb, permanent magnet 3b, magnetic pole piece 4b, main flux gap 2 and magnetic pole piece 4a.

Then, when the movable yokes 30a and 30b are moved forward and backward, that is, brought closer together or further apart from each other by the rotation of the shaft 13, the opposing distance between a pair of inovable yokes 30a and 30b, that is, the auxiliary flux gap 9 can change continuously, to vary the intensity of the magnetic field formed in the main flux gap 2 between the magnetic pole pieces 4a and 4b, also continuously. That is, when the distance between the movable yokes 30a and 30b is made larger, the intensity of the magnetic field in the main flux gap 2 becomes weak and vice versa.

For the application use to ESR system, it is necessary to linearly vary the magnetic field within a range of up to about ± 10⁻² tesla (100 gauss). However, such a change in the magnetic field is intended to be attained accurately, and if reliance is placed only on moving the movable yokes, there may be some instances e.g. in very large or in very small scale systems, where control for the movable yokes is troublesome or that the entire device is over complicated or over expensive or incapable of easy and reliable operation.

In view of this, in another aspect of the present invention, approved performance has been attained by a construction in which a secondary magnetic field is deliberately induced in one or more auxiliary (variable) flux gaps by means of solenoid or induction coil devices disposed around the movable yoke means defining such auxiliary flux gaps. Such a construction is described below with reference to Figure 2.

Then by generating a predetermined high magnetic field in a space between opposed pole surfaces of movable yoke members while controlling the distance therebetween; and then by supplying a predetermined DC current to the solenoid coil or coils having adjusted and set distance between the opposing pole surfaces to a predetermined level, it is possible to modify the flux in the auxiliary flux gap or gaps 9. This in turn modifies the resistance in the flux path of the system with increased sensitivity.

By these means it is more easily possible to maintain the magnetic field in the main fixed flux gap 2 with high accuracy and with ability to adjust to within say about ± 10⁻⁴ tesla (1 gauss), without unwanted change of the magnetic field distribution in the space 2, and with the range of adjustment being variable in substantially a linear manner through about ± 10⁻² tesla (100 gauss).

In such a construction, the coil disposed around the movable yoke member merely conducts variation of magnetic field of about +/- 10⁻² tesla (100 gauss), which does not hinder the overall size reduction of the device much.

Further, since the coil is disposed well spaced apart from the permanent magnets, there is no worry that undesirable effects due to the heat generation of the coil are passed to the permanent magnets (for example, change of the magnetic field intensity along with the change of the temperature of the permanent magnets, making the degree of uniformity of the magnetic field unstable).

Reference will now be made to Figure 2, in which a magnetic field is generated in the auxiliary flux gap 9 by means of an induction coil disposed around a movable yoke member. In this embodiment a solenoid coil 50 is disposed around the sleeves 15a and 15b which surround the movable yoke members 30a and 30b.

In Figure 2, the induction coil 50 is shown disposed around the entire movable yoke members. However, the disposition of the coil is not necessarily limited only to those dispositions as shown in the drawings and other convenient dispositions can be employed so long as a weak magnetic field can be superimposed through the movable yoke members to the or each auxiliary flux gap 9. The position of each coil is selected depending on the capacity of DC current applied, wire diameter and number of turn of coil, disposition and shape of the movable yoke member, etc.

A magnetic field of uniform intensity, for example, of about 0.35 tesla (3500 gauss) is generated in the auxiliary flux gap 9 by adjusting the opposing distance between the or each movable yoke member. Then, by applying a DC current to the solenoid coil 50 to superimpose a weak magnetic field of about ± 10⁻² tesla (100 gauss) over the magnetic field in the auxiliary flux gap 9, the magnetic field in the main flux gap 2 can be varied continuously with high precision; and also, the magnetic field intensity can be varied generally in a stable and linear fashion, while at the same time, the high degree of uniformity for the magnetic field intensity in the main flux gap or measuring space 2 can still be maintained.

As shown in Figure 1 and Figure 2, in the device according to the present invention, the magnetic field in the main flux gap 2 defined between the opposing permanent magnets can be varied continuously by changing the distance between a pair of opposed movable yoke members.

The measured results from a test example will now be given.

The magnetic field generating device for ESR system shown in Figure 2 was used and the opposing distance between the movable yoke members 30a and 30b was adjusted for the aimed value of the magnetic field intensity of 0.335 tesla (3350 G) in the main flux gap 2. Then, when the magnetic field intensity in the main flux gap 2 was measured, a high degree of uniformity could be obtained at 20 ppm within a circle with radius of 5mm around the centre of the main flux gap 2 as shown in Figure 5.

Further, when a DC current was applied to the solenoid coil 50 to superimpose a magnetic field of about ± 10⁻² tesla (100 gauss) over the magnetic field in the auxiliary flux gap 9, the high degree of uniformity of the magnetic field intensity in the main flux gap did not change.

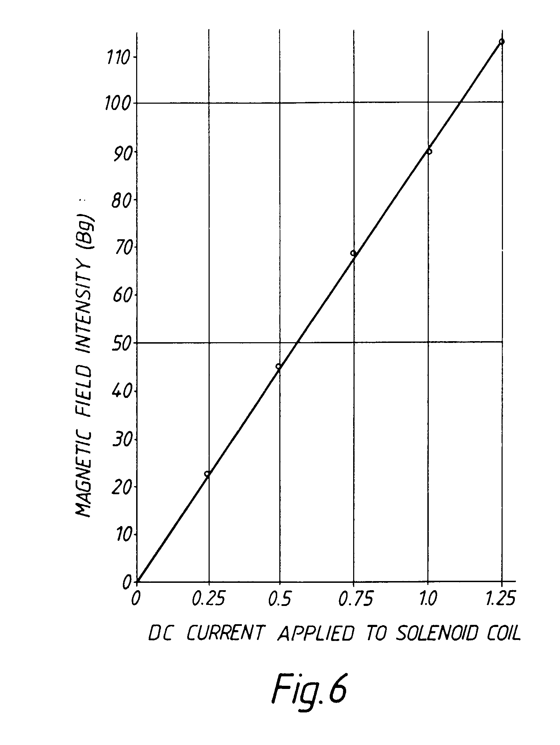

Figure 6 shows a relationship between the DC current applied to the solenoid coil 50 and the change of the magnetic field intensity (Bg) in the main flux gap 2. It can be confirmed also from the graph that the magnetic field intensity can be stably varied linearly by the device according to the present invention.

By the measures proposed according to this invention as outlined above, it is usually possible to achieve a reliable systein, with the capability that the field intensity in the main flux gap can be changed continuously with fine adjustment within predetermined limits e.g., in the range of ± 10⁻² tesla (100 gauss), while preserving uniformity of better than 0.01 % in the field intensity in the main flux gap where a test object is to be measured. As can be seen below these adjustments can usually be made with high accuracy and precision to within say ± 10⁻⁴ tesla (l gauss).

## Claims

1. A magnetic field generating device for an electron spin resonance ("ESR") system in which two permanent magnets (3a, 3b) are attached to two arms (1a, 1b) of a yoke so that such magnets (3a, 3b) are in opposed spaced relationship, a main flux gap (2) being located between such magnets (3a, 3b),
and characterized in that a means is provided for continuously varying the intensity of the magnetic field in the main flux gap (2) located between such magnets;
said means comprising two movable yoke members (30a, 30b) provided between the yoke arms (1a, 1b), each of said movable yoke members being in indirect contact with one of the yoke arms (1a, 1b) and said movable yoke members (30a, 30b) being arranged opposed to one another so as to define an auxiliary flux gap (9) between them, whereby the flux path (C) which extends through said main flux gap (2) also extends through said yoke arms (1a, 1b), said movable yoke members (30a, 30b) and said auxiliary gap (9);
and including means (13) whereby said two movable yoke members (30a, 30b) are simultaneously movable towards or away from one another so that the auxiliary flux gap (9) which is formed between the said movable yoke members (30a, 30b) is continuously variable.

2. A device according to claim 1 and wherein each said movable yoke member (30a, 30b) moves within a stationary sleeve (15a, 15b) fixed to a respective yoke arm (1a, 1b), the flux path (C) extending through said main flux gap (2) and said auxiliary flux gap (9) also extends through said permanent magnets (3a, 3b), said fixed yoke arms (1a, 1b), said sleeves (15a, 15b) and said movable yoke members (30a, 30b).

3. A device according to either of claims 1 or 2, and wherein said pair of movable yoke members (30a, 30b) are screw-coupled to oppositely threaded portions of a shaft (13) disposed extending between the stationary yoke arms (1a, 1b) rotation of said shaft (13) being effective to move said movable yoke members (30a, 30b) simultaneously towards or away from one another in dependence upon the direction of rotation of the shaft (13), thereby to alter the size of the auxiliary gap (9).

4. A device according to any one or more of the preceding claims 1 to 3, and including an induction coil surrounding said movable yoke members (30a, 30b), energization of the coil to a predetermined extent, being effective to alter the magnetic field intensity in the auxiliary flux gap (9) between the said movable yoke members (30a, 30b), this in turn, being effective to alter the field intensity in the main flux gap (2).

5. A device according to any one or more of the preceding claims 1 to 4, and and wherein the length and resistance of the magnetic flux path (C) are substantially equal and symmetrical with respect to a median plane (16).

## Patentansprüche

1. Eine ein Magnetfeld erzeugende Vorrichtung für ein Elektronen-Spin-Resonanzsystem ("ESR"), bei welcher zwei Permanentmagnete (3a, 3b) an zwei Armen (1a, 1b) eines Joches derart befestigt sind, daß diese Magnete (3a, 3b) mit Abstand einander gegenüberliegend angeordnet sind, wobei zwischen diesen Magneten (3a, 3b) ein Haupt-Flußspalt (2) liegt, dadurch gekennzeichnet, daß ein Mittel zum kontinuierlichen Ändern der Feldstärke des Magnetfeldes im zwischen diesen Magneten liegenden Haupt-Flußspalt (2) vorgesehen ist;
wobei das besagte Mittel zwei bewegbare Jochteile (30a, 30b) aufweist, die zwischen den Jocharmen (1a, 1b) angeordnet sind und jedes der besagten bewegbaren Jochteile in indirektem Kontakt mit einem der Jocharme (1a, 1b) steht und die besagten bewegbaren Jochteile (30a, 30b) so einander gegenüberliegend angeordnet sind, daß sie zwischen sich einen Hilfs-Flußspalt (9) begrenzen, wodurch der sich durch den besagten Haupt-Flußspalt (2) erstreckende Flußweg (C) auch durch die besagten Jocharme (1a, 1b), die besagten bewegbaren Jochteile (30a, 30b) und den besagten Hilfs-Spalt (9) verläuft und daß
ein Mittel (13) vorhanden ist, durch welches die beiden besagten bewegbaren Jochteile (30a, 30b) gleichzeitig aufeinander zu und voneinander weg bewegbar sind, so daß der zwischen den besagten bewegbaren Jochteilen (30a, 30b) gebildete Hilfs-Flußspalt (9) kontinuierlich veränderbar ist.

2. Eine Vorrichtung nach Anspruch 1, bei welcher jedes der besagten bewegbaren Jochteile (30a, 30b) sich in einer ortsfesten Buchse (15a, 15b) bewegt, die jeweils an einem Jocharm (1a, 1b) befestigt ist, wobei der sich durch den besagten Haupt-Flußspalt und den besagten Hilfs-Flußspalt erstreckende Flußweg (C) auch durch die besagten Permanentmagnete (3a, 3b), die besagten festen Jocharme (1a, 1b), die besagten Buchsen (15a, 15b) und die besagen bewegbaren Jochteile (30a, 30b) verläuft.

3. Eine Vorrichtung nach Anspruch 1 oder 2, bei welcher das besagte Paar bewegbarer Jochteile (30a, 30b) über Schraubgewinde mit ein Gegengewinde tragenden Teilen einer Welle (13) gekoppelt sind, die sich zwischen den ortsfesten Jocharmen (1a, 1b) erstreckend angeordnet ist, und eine Drehung der besagten Welle (13) dazu führt, die besagten bewegbaren Jochteile (30a, 30b) in Abhängigkeit von der Drehrichtung der Welle (13) gleichzeitig aufeinander zu oder voneinander weg zu bewegen, wodurch die Größe des Hilfs-Spaltes (9) verändert wird.

4. Eine Vorrichtung nach einem oder mehreren der vorhergehenden Ansprüche 1 bis 3 und mit einer die besagten bewegbaren Jochteile (30a, 30b) umgebenden Induktionsspule, wobei die Erregung der Spule in einer vorgegebenen Größe eine Änderung der magnetischen Feldstärke im Hilfs-Flußspalt (9) zwischen den besagten bewegbaren Jochteilen (30a, 30b) bewirkt, was dann zu einer Änderung der Feldstärke im Haupt-Flußspalt (2) führt.

5. Eine Vorrichtung nach einem oder mehreren der vorhergehenden Ansprüche 1 bis 4, bei welcher die Länge und der Widerstand des magnetischen Flußweges (C) im Bezug auf eine Mittelebene (16) im wesentlichen gleich und symmetrisch sind.

## Revendications

1. Dispositif de production d'un champ magnétique pour un système à résonance de spin électronique ("ESR") dans lequel deux aimants permanents (3a, 3b) sont fixés sur deux bras (1a, 1b) d'une culasse de manière que de tels aimants (3a, 3b) soient écartés et en regardd l'un de l'autre, un entrefer principal (2) étant constitué entre de tels aimants (3a, 3b),
et caractérisé en ce qu'il comprend un moyen destiné à faire varier de manière continue l'intensité du champ magnétique dans l'entrefer principal (2) présent entre de tels aimants;
ledit moyen comprenant deux éléments formant culasse mobile (30a, 30b) situés entre les bras de culasse (1a, 1b), chacun desdits éléments formant culasse mobile étant en contact indirect avec l'un des bras de culasse (1a, 1b) et lesdits éléments formant culasse mobile (30a, 30b) étant disposés en regard l'un de l'autre de manière à définir un entrefer secondaire (9) entre eux, ce par quoi le trajet de flux (C) qui s'étend à travers ledit entrefer principal (2) s'étend aussi à travers lesdits bras de culasse (1a, 1b), lesdits éléments formant culasse mobile (30a, 30b) et ledit entrefer secondaire (9);
et incluant un moyen (13) par lequel lesdits deux éléments formant culasse mobile (30a, 30b) peuvent être déplacés simultanément l'un vers l'autre ou à l'écart l'un de l'autre de manière que l'entrefer secondaire (9), qui est formé entre lesdits éléments formant culasse mobile (30a, 30b), puisse être modifié en continu.

2. Dispositif selon la revendication 1, et dans lequel chacun desdits éléments formant culasse mobile (30a, 30b) se déplace à l'intérieur d'un fourreau fixe (15a, 15b) fixé sur un bras de culasse respectif (1a, 1b), le trajet de flux (C) s'étendant à travers ledit entrefer principal (2) et ledit entrefer secondaire (9) s'étend aussi à travers lesdits aimants permanents (3a, 3b), lesdits bras de culasse fixes (1a, 1b), lesdits fourreaux (15a, 15b) et lesdits éléments formant culasse mobile (30a, 30b).

3. Dispositif selon l'une ou l'autre des revendications 1 ou 2, et dans lequel ladite paire d'éléments formant culasse mobile (30a, 30b).est couplée par vis à des parties filetées en sens opposé d'un arbre (13) s'étendant entre les bras de culasse fixes (1a, 1b), la rotation dudit arbre (13) agissant de manière à déplacer lesdits éléments formant culasse mobile (30a, 30b) simultanément l'un vers l'autre ou à l'écart l'un de l'autre en fonction du sens de rotation de l'arbre (13), afin de modifier, par ce moyen, la largeur de l'entrefer secondaire (9).

4. Dispositif selon l'une ou plusieurs des revendications 1 à 3 précédentes, et incluant une bobine d'induction entourant lesdits éléments formant culasse mobile (30a, 30b), l'alimentation de la bobine dans une plage prédéterminée ayant pour effet de modifier l'intensité du champ magnétique dans l'entrefer secondaire (9) entre lesdits éléments formant culasse mobile (30a, 30b), ceci permettant, en conséquence, de modifier l'intensité du champ dans l'entrefer principal (2).

5. Dispositif selon l'une ou plusieurs des revendications 1 à 4 précédentes, et dans lequel la longueur et la résistance du trajet de flux magnétique (C) sont sensiblement égales et symétriques par rapport à un plan médian (16).
